# EUROPEAN PATENT SPECIFICATION

(11) **EP 1 999 799 B1**
(45) Date of publication and mention of the grant of the patent: **07.07.2010**
(21) Application number: 07712459.2
(22) Date of filing: 06.03.2007
(51) Int. Cl.: H01L 31/055, H01L 31/0216

(54) **DEVICE FOR CONVERTING ELECTROMAGNETIC RADIATION ENERGY INTO ELECTRICAL ENERGY AND METHOD OF MANUFACTURING SUCH A DEVICE**
EINRICHTUNG ZUM UMSETZEN VON ELEKTOMAGNETISCHER STRAHLUNGSENERGIE IN ELEKTRISCHE ENERGIE UND VERFAHREN ZUR HERSTELLUNG EINER SOLCHEN EINRICHTUNG
DISPOSITIF POUR LA CONVERSION D'ENERGIE DE RAYONNEMENT ELECTROMAGNETIQUE EN ENERGIE ELECTRIQUE ET PROCEDE DE FABRICATION D'UN TEL DISPOSITIF

(30) Priority: 20.03.2006 NL 2000033
(43) Date of publication of application: 10.12.2008
(73) Proprietor: Technische Universiteit Eindhoven, 5612 AZ Eindhoven (NL)
(72) Inventor: HINTZEN, Hubertus Theresia Jozef Maria, NL-5646 JE Eindhoven (NL); VAN DE SANDEN, Mauritius Cornelius Maria, NL-5017 JH Tilburg (NL)
(74) Representative: Smeets, Eugenius Theodorus J. M.
(86) International application number: PCT/EP2007/052089
(87) International publication number: WO 2007/107452

(56) References cited:
- DIAW D: "Effect of ion-implanted Eu<+3> on the conversion efficiency of amorphous silicon solar cell" SOLAR ENERGY MATERIALS AND SOLAR CELLS, ELSEVIER SCIENCE PUBLISHERS, AMSTERDAM, NL, vol. 53, no. 3-4, June 1998 (1998-06), pages 379-383, XP004148864 ISSN: 0927-0248 cited in the application
- XIE R-J ET AL: "PREPARATION AND LUMINESCENCE SPECTRA OF CALCIUM- AND RARE-EARTH (R = EU, TB, AND PR)-CODOPED ALPHA-SIALON CERAMICS" JOURNAL OF THE AMERICAN CERAMIC SOCIETY, BLACKWELL PUBLISHING, MALDEN, MA, US, vol. 85, no. 5, 1 October 2000 (2000-10-01), pages 1229-1234, XP001151981 ISSN: 0002-7820
- KAWANO K ET AL: "Application of rare-earth complexes for photovoltaic precursors" SOLAR ENERGY MATERIALS AND SOLAR CELLS, ELSEVIER SCIENCE PUBLISHERS, AMSTERDAM, NL, vol. 48, no. 1-4, November 1997 (1997-11), pages 35-41, XP004111830 ISSN: 0927-0248

## Description

The invention relates to a device for converting electromagnetic radiation energy into electrical energy, which device comprises at least a photovoltaic element with a radiation-sensitive surface, wherein a cover layer of a material comprising a silicon compound to which a rare earth has been added is present on the radiation-sensitive surface of the photovoltaic element. Such a device is better known as a photovoltaic solar cell and forms an attractive alternative energy source. The invention also relates to a method of manufacturing such a device.

Such a device and method are known from the article "Effect of ion-implanted Eu on the conversion of amorphous silicon solar cell", by D. Diaw, published in Solar Energy Materials and Solar Cells, volume 53, issues 3-4, 10 June 1998, pp 379-383. An amorphous silicon solar cell is described therein whose radiation-sensitive surface is covered by a covering layer of a material comprising silicon dioxide. Europium atoms have been added to the covering layer of anti-reflecting SiO₂ glass so as to achieve an emission therein of light having a wavelength close to the maximum spectral response of the cell. The europium is introduced into the covering layer in the form of Eu⁺ ions by means of ion implantation.

A disadvantage of the device is that this solar cell still has an insufficient conversion ratio. In addition, the manufacture of the known device is less suitable for mass production.

It is accordingly an object of the present invention to provide a device of the kind mentioned in the opening paragraph which does not have the disadvantage mentioned above, or at least to a much lesser degree, i.e. which has a comparatively high conversion ratio, and which is easy to manufacture.

According to the invention; a device of the kind mentioned in the opening paragraph is for this purpose **characterized in that** that the material of the covering layer comprises a compound of silicon and nitrogen. The invention is based first and foremost on the recognition that a compound of silicon and nitrogen is highly suitable for use as a compound with absorption and emission in the portion of the (solar) spectrum that is an optimum for (silicon) solar cells. Besides, the invention is based on the recognition that such a compound can also be readily obtained in (poly)crystalline form, which benefits the efficiency of absorption and emission, thus improving the conversion ratio of the solar cell.

The invention is also based on the recognition that compounds of silicon and nitrogen have a higher refractive index than compounds of silicon and oxygen. Thus the refractive index of the SiO₂ of the covering layer of the known device is approximately 1.4, whereas the refractive index of, for example, Si₃N₄ lies between 1.7 and 2. These values lie close to an optimum for silicon (refractive index approximately 3.4 to 4 in the wavelength domain of 0.5 to I micron). This means that it is possible with a layer of Si₃N₄ on silicon to obtain substantially both phase extinction and amplitude extinction for a given wavelength of electromagnetic radiation. This renders a further improvement of the conversion ratio of the solar cell possible if the latter is provided with a covering layer according to the invention, which forms both a spectral conversion layer for one part of the (solar) spectrum and an anti-reflection layer for a (different) part of the solar spectrum.

Furthermore, such a silicon-nitrogen compound, possibly incorporated in a matrix of materials such as Si₃N₄ or SiO₂ and TiO₂, is not toxic, which is a major advantage compared with, for example, a solar cell of which (part of) the covering layer comprises a II-VI compound such as CdS/Se/Te.

Finally, the invention is based on the recognition that a device according to the invention can also be manufactured by means of a technology that is suitable for mass production.

In a preferred embodiment, the compound of silicon and nitrogen to which a rare earth element has been added has a maximum absorption in the wavelength domain of 350 to 550 nm and a maximum emission in the wavelength domain of 550 to 950 nm. A considerable improvement in the conversion ratio of the solar cell can be achieved thereby, while various compounds of silicon and nitrogen that comply with these requirements are available.

In a first version, the compound of silicon and nitrogen comprises Sr₂Si₅N₈. A rare earth such as europium has been added as a dopant.

A second version has LaSi₃N₅ as the compound of silicon and nitrogen. This compound, too, is doped, for example with bivalent europium. In a modification of this version, a La-N pair is replaced with a Ba-O pair.

In a third version, the compound of silicon and nitrogen comprises CaAlSiN₃, for example again doped with Eu.

The rare earth element is preferably an element chosen from the group comprising europium, cerium and terbium, and preferably it is europium that is chosen from this group.

In a favorable version, a Si-N pair in the compound of silicon and nitrogen is replaced with an Al-O pair. Other charge-neutral substitutions are also possible. Thus a Si-Sr pair or a Si-Be pair may be replaced with an Al-La pair. Part of the Si may be replaced with Ge and part of the Al, if present, may be replaced with B. The desired properties of the material of the covering layer, such as its absorption and/or emission efficiency and the wavelength at which these are a maximum, can thus be optimized. This may be further refined in that further and/or other elements are added and/or substituted. Thus, for example, the Sr or part thereof in Sr₂Si₅N₈ may be replaced with alternative bivalent elements such as Ca and/or Ba. A mixture of two or more suitable elements may also be used to advantage.

In another favorable embodiment, the compound of silicon and nitrogen is present within a matrix of Si₃N₄. It is comparatively favorable in such a matrix to realize an anti-reflection effect of the covering layer. The manufacture of such a covering layer may take place, for example, by means of PECVD (= Plasma Enhanced Chemical Vapor Deposition).

A further favorable embodiment is **characterized in that** the compound of silicon and nitrogen (doped with a rare earth ion) is embedded in a matrix of SiO₂ and TiO₂. TiO₂ in particular has a comparatively high refractive index of approximately 2.5. This renders it easier to give the refractive index of the covering layer a value that is an optimum for an anti-reflection layer. Multilayers of, for example, SiO₂ alternating with TiO₂ may also be advantageously used. It is possible in this manner to obtain a good anti-reflection effect of the covering layer over a wider portion of the (solar) spectrum.

In a particularly favorable version of a device according to the invention, therefore, both the thickness of the covering layer and the refractive index of the material of the spectrally converting covering layer are chosen such that the covering layer at the same time acts as an anti-reflection layer. The thickness may be greater than the optimum value for achieving an anti-reflection effect if this is necessary for obtaining a sufficient absorption.

The most promising results are achievable with a device which has a silicon semiconductor element as its radiation-sensitive photovoltaic element. Such an element is, for example, a pn or pin diode in monocrystalline or polycrystalline or amorphous silicon, or in a combination of two or more of these materials.

According to the invention, a method of manufacturing a device for converting electromagnetic radiation energy into electrical energy, which device comprises at least a photovoltaic element with a radiation-sensitive surface, whereby the radiation-sensitive surface of the photovoltaic element is provided with a covering layer of a material comprising a silicon compound to which a rare earth is added, is **characterized in that** a compound of silicon and nitrogen is chosen for the material of the covering layer.

In a particularly favorable modification of the method according to the invention, the material of the compound of silicon and nitrogen in the covering layer is manufactured in (poly)crystalline form. Such a (poly)crystalline material contributes to a further improvement of the conversion ratio of the solar cell. In this method, crystals of the silicon-nitrogen compound (doped with the rare earth element) are often incorporated into an amorphous matrix.

An attractive and suitable technology for providing such a (poly)crystalline material in an otherwise amorphous covering layer is the sol-gel technology. This technology also renders possible a (subtle) variation in the composition of the composite material of the covering layer. In addition, this technology is comparatively suitable for mass manufacture.

In another modification of the method according to the invention, the material of the doped silicon-nitrogen compound in the covering layer is amorphously formed. The improvement in conversion ratio may be smaller in this case, but the method offers good possibilities for an inexpensive manufacture on an industrial scale. Thus a CVD (=Chemical Vapor Deposition) method may be used in this case for forming the covering layer. Particularly suitable here is a technology such as PECVD. The doped silicon-nitrogen compound is often incorporated into or forms part of a matrix of a different, also amorphous material in these cases.

These and further properties, aspects and advantages of the invention will be discussed in more detail below with reference to preferred embodiments of the invention, and in particular with reference to the accompanying Figures, in which:
Fig. 1 diagrammatically shows a device according to the invention in a cross-section taken perpendicularly to the thickness direction, and
Fig. 2 shows the spectral properties of the material of the covering layer of the device of Fig. 1.

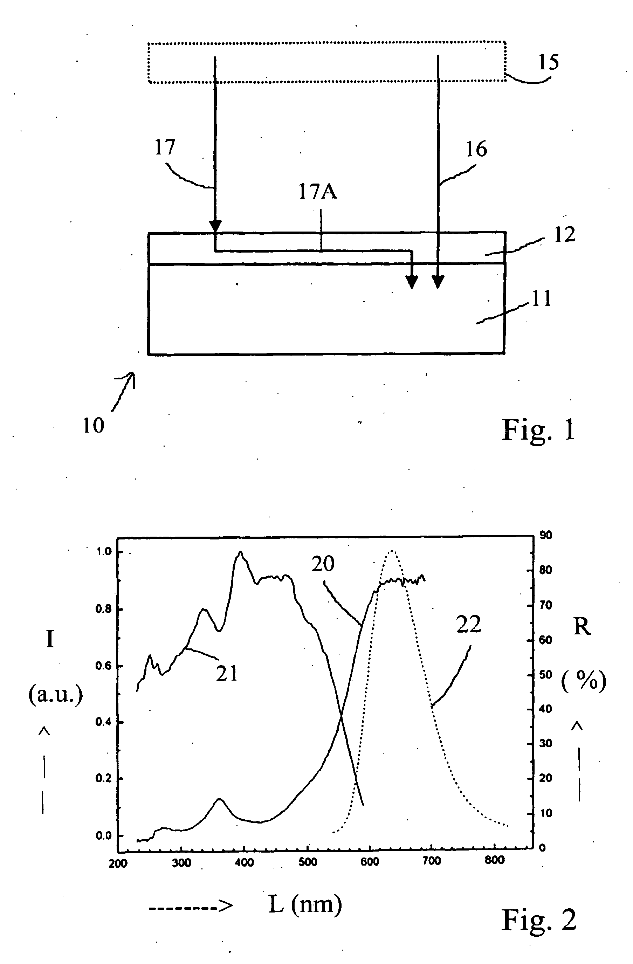

Fig. 1 diagrammatically shows a device 10 according to the invention in a cross-section taken perpendicularly to the thickness direction. The device 10 in this example comprises a silicon solar cell 11 which is covered by a covering layer 12. The solar cell 11 in this example comprises a monocrystalline silicon substrate in which a pn junction has been provided which runs parallel to the surface of the cell 11 and which is not shown in the Figure. Upper and lower contacts for receiving the energy generated by the cell from solar radiation 15 have also not been depicted in the Figure. The upper contacts are either transparent or strip-shaped, such that the surface of the silicon semiconductor element of the solar cell is radiation-sensitive or at least radiation-transmitting.

An arrow 16 to the right of the solar radiation 15 represents radiation with a wavelength close to the maximum response of monocrystalline silicon, i.e. a wavelength of approximately 600 to 700 nm. This radiation 16 is guided directly into the solar cell 11, which takes place with a high efficiency owing to the anti-reflection properties of the covering layer 12. An arrow 17 to the left of the solar spectrum 15 indicates radiation of comparatively short wavelength, for example blue radiation. The conversion ratio of the solar cell is comparatively low for this radiation.

Since a polycrystalline compound of silicon and nitrogen doped with europium is present in the covering layer, this blue radiation 17 is converted into radiation with a wavelength between 600 and 700 nm in the covering layer 12. This is indicated by means of the horizontal portion 17A of the arrow 17. The result is that the radiation 17 also enters the solar cell as an orange/red radiation, together with the radiation 16, so that the conversion ratio of the solar cell is particularly high. Obviously, the horizontal character of the portion 17A has no physical/geometrical significance, and the radiation 17 - after being converted into radiation of a greater wavelength - will enter the solar cell 11 in the extended direction of the vertical arrow 17. The covering layer 12 will then act as an anti-reflection layer also for the radiation 17.

The covering layer 12 has a comparatively high refractive index owing to the use of the silicon-nitrogen compound therein, so that the physical requirements holding for a satisfactory operation as an anti-reflection coating are better and/or more easily complied with. The thickness and refractive index of the material of the covering layer 12 are chosen such that extinction takes place in the covering layer 12 both as regards the phase and as regards the amplitude of the relevant (orange/red) radiation. If so desired, a slightly greater thickness is preferably chosen than is an optimum for achieving the AR (anti-reflection) effect so as to create a sufficient path length for absorbing radiation with a wavelength around the blue.

The optically active silicon-nitrogen compound in this example, comprising Sr₂Si₅N₈:Eu here, is accommodated in a matrix of SiO₂ and TiO₂. When a multilayer structure thereof is used, a good anti-reflection effect of the covering layer 12 can be realized over a somewhat wider wavelength range, for example for the entire domain from 600 to 700 nm instead of for 650 nm.

The exact operation of the covering layer 12 will be illustrated in more detail with reference to Fig. 2.

Fig. 2 shows the spectral properties of the material of the covering layer 12 of the device 10 of Fig. 1. Curve 20 represents the reflection R as a function of the wavelength L, and curves 21 and 22 show the intensities I of the excitation and the emission, respectively, as a function of the wavelength L. Curve 20 illustrates that the radiation of the solar spectrum 15 of Fig. 1 is well absorbed in the blue portion, while curve 21 shows that an efficient excitation takes place in response to the absorbed radiation, with a conversion of the absorbed radiation into 650 nm radiation (emission curve 22).

The device 10 of this example is manufactured, for example, as follows by a method according to the invention.

First the solar cell 11 is manufactured in that, for example, a p-type surface zone is provided in an n-type Si substrate by means of diffusion from the gas phase. Then the lower contacts and the strip-shaped upper contacts are provided on the solar cell 11.

The manufacture of the covering layer 12 starts with crystalline Sr₂Si₅N₈:Eu powders obtained as described in a European Patent Application published under no. EP 1 104 799 A1 on June 6th, 2001. In this example, said powders are incorporated into a covering layer which comprises a matrix on the basis of SiO₂ and TiO₂ that was manufactured in a sol-gel process. Particulars on this matrix and its manufacture can be found in, for example, the publication "Optical properties of SiO2 TiO2 sol-gel thin films" by P. Chrysicopolou et al., Journal of Materials Science 39 (2004) 2835-2839.

The crystalline powders mentioned above are mixed in a desired ratio into the solution of the matrix materials. Surfactants may advantageously be used for this. Such surfactants may also be provided on the surface of the powders. The suspension thus obtained is applied to the solar cell by means of dipping or spraying followed by a baking process. If nanopowders of the silicon-nitrogen compound are desired, these may be obtained, for example, by milling, or alternatively by etching or by oxidation of the powders followed by selective etching of the resulting oxides. Should the luminescent quality of the obtained powders deteriorate owing to the use of such processes, various techniques are available for restoring this quality again, such as a thermal treatment.

The invention was described above with reference to a preferred embodiment thereof. Those skilled in the art will be aware that numerous modification may be applied thereto without departing from the scope of the appended claims. The description should accordingly be regarded as illustrative rather than limitative, and no restrictions are to be concluded therefrom other than those expressly stated in the claims.

Thus the invention may also be used to advantage in solar cells comprising a semiconductor material other than silicon, such as a III-V material. The solar cell may alternatively be formed on the basis of an organic material or be of the so-termed hybrid type. The solar cell may be constructed not only from monocrystalline silicon, but also from polycrystalline (micro-, nanocrystalline, etc.) silicon. It is also possible for (part of) the solar cell to be made from an amorphous material.

It is noted that the silicon-nitrogen compound doped with rare earth may be accommodated in an organic, for example polymeric layer instead of in an inorganic matrix.

It is finally noted that the covering layer may advantageously be provided with a material that performs a so-termed up-conversion. In such a case radiation with a wavelength around 1000 nm is converted into radiation with a wavelength around 650 nm. This may be realized, for example, by means of erbium, as described in the publication "The red emission in two and three step up-conversion process in a doped erbium SiO2-TiO2 sol-gel powder" by J. Castanede et al., Journal of Luminescence 102-103 (2003) 504-509.

## Claims

1. A solar cell device (10) for converting electromagnetic radiation energy into electrical energy, which device comprises at least a photovoltaic element (11) with a radiation-sensitive surface, wherein a covering layer (12) of a material comprising a silicon compound to which a rare earth has been added is present on the radiation-sensitive surface of the photovoltaic element (11), **characterized in that** the material of the covering layer (12) comprises a compound of silicon and nitrogen.

2. A device as claimed in claim 1, **characterized in that** the compound of silicon and nitrogen substantially absorbs between 350 nm and 550 nm and substantially emits between 550 and 950 mm.

3. A device as claimed in claim 1 or 2, **characterized in that** the compound of silicon and nitrogen comprises Sr₂Si₅N₈.

4. A device as claimed in claim 1 or 2, **characterized in that** the compound of silicon and nitrogen comprises LaSi₃N₅.

5. A device as claimed in claim 1 for 2, **characterized in that** the compound of silicon and nitrogen comprises CaAlSiN₃.

6. A device as claimed in any one of the preceding claims, **characterized in that** the rare earth element comprises an element from the group comprising europium, cerium and terbium, and **in that** the element preferably comprises europium.

7. A device as claimed in any one of the preceding claims, **characterized in that** a Si-N pair in the compound of silicon and nitrogen is replaced through substitution by an Al-O pair.

8. A device as claimed in any one of the preceding claims, **characterized in that** the compound of silicon and nitrogen is embedded in a matrix of SiO₂ and TiO₂.

9. A device as claimed in any one of the claims 1 to 7, **characterized in that** the compound of silicon and nitrogen is embedded in a matrix of Si₃N₄.

10. A device as claimed in any one of the preceding claims, **characterized in that** the thickness of the covering layer and the refractive index of the material of the covering layer are chosen such that the covering layer acts as an anti-reflection coating, or the thickness is chosen to be so much greater than the thickness as specified above as is necessary for obtaining a sufficient absorption.

11. A device as claimed in any one of the preceding claims, **characterized in that** the radiation-sensitive photovoltaic element comprises a silicon semiconductor element.

12. A method of manufacturing a solar cell device (10) for converting electromagnetic radiation energy into electrical energy, which device comprises at least a photovoltaic element (11) with a radiation-sensitive surface, whereby the radiation-sensitive surface of the photovoltaic element (11) is provided with a covering layer (12) of a material comprising a silicon compound to which a rare earth is added, **characterized in that** a compound of silicon and nitrogen is chosen for the material of the covering layer (12).

13. A method as claimed in claim 12, **characterized in that** the material of the compound of silicon and nitrogen in the covering layer is formed so as to be crystalline.

14. A method as claimed in claim 13, **characterized in that** the covering layer is formed by means of a sol-gel technique.

15. A method as claimed in claim 12, **characterized in that** the material of the compound of silicon and nitrogen in the covering layer is formed so as to be amorphous.

16. A method as claimed in claim 15, **characterized in that** the covering layer is formed by means of a plasma-enhanced chemical vapor deposition technique.

## Patentansprüche

1. Solarzellenvorrichtung (10) zum Umwandeln elektromagnetischer Strahlungsenergie in elektrische Energie, wobei die Vorrichtung mindestens ein Photovoltaik-Element (11) mit einer strahlungsempfindlichen Oberfläche umfasst, wobei eine Deckschicht (12) aus einem Material, das eine Siliziumverbindung umfasst, der eine Seltenerde beigegeben ist, auf der strahlungsempfindlichen Oberfläche des Photovoltaik-Elements (11) vorhanden ist, **dadurch gekennzeichnet, dass** das Material der Deckschicht (12) eine Verbindung aus Silizium und Stickstoff umfasst.

2. Vorrichtung nach Anspruch 1, **dadurch gekennzeichnet, dass** die Verbindung aus Silizium und Stickstoff im Wesentlichen zwischen 350 nm und 550 nm absorbiert und im Wesentlichen zwischen 550 und 950 nm emittiert.

3. Vorrichtung nach Anspruch 1 oder 2, **dadurch gekennzeichnet, dass** die Verbindung aus Silizium und Stickstoff Sr₂Si₅N₈ umfasst.

4. Vorrichtung nach Anspruch 1 oder 2, **dadurch gekennzeichnet, dass** die Verbindung aus Silizium und Stickstoff LaSi₃N₅ umfasst.

5. Vorrichtung nach Anspruch 1 oder 2, **dadurch gekennzeichnet, dass** die Verbindung aus Silizium und Stickstoff CaAlSiN₃ umfasst.

6. Vorrichtung nach einem der vorangehenden Ansprüche, **dadurch gekennzeichnet, dass** das Seltenerdenelement ein Element aus der Gruppe umfasst, die Europium, Cerium und Terbium umfasst, und dass das Element vorzugsweise Europium umfasst.

7. Vorrichtung nach einem der vorangehenden Ansprüche, **dadurch gekennzeichnet, dass** ein Si-N-Paar in der Verbindung aus Silizium und Stickstoff durch ein Al-O-Paar substituiert wird.

8. Vorrichtung nach einem der vorangehenden Ansprüche, **dadurch gekennzeichnet, dass** die Verbindung aus Silizium und Stickstoff in eine Matrix aus SiO₂ und TiO₂ eingebettet ist.

9. Vorrichtung nach einem der Ansprüche 1 bis 7, **dadurch gekennzeichnet, dass** die Verbindung aus Silizium und Stickstoff in eine Matrix aus Si₃N₄ eingebettet ist.

10. Vorrichtung nach einem der vorangehenden Ansprüche, **dadurch gekennzeichnet, dass** die Dicke der Deckschicht und der Brechungsindex des Materials der Deckschicht so gewählt sind, dass die Deckschicht als eine Entspiegelungsbeschichtung fungiert, oder dass die Dicke um einen solchen Betrag größer als die oben genannten Dicke gewählt ist, wie notwendig ist, um eine ausreichende Absorption zu erreichen.

11. Vorrichtung nach einem der vorangehenden Ansprüche, **dadurch gekennzeichnet, dass** das strahlungsempfindlichen Photovoltaik-Element ein Silizium-Halbleiterelement umfasst.

12. Verfahren zur Herstellung einer Solarzellenvorrichtung (10) zum Umwandeln elektromagnetischer Strahlungsenergie in elektrische Energie, wobei die Vorrichtung mindestens ein Photovoltaik-Element (11) mit einer strahlungsempfindlichen Oberfläche umfasst, wobei die strahlungsempfindliche Oberfläche des Photovoltaik-Elements (11) mit einer Deckschicht (12) aus einem Material versehen wird, das eine Siliziumverbindung umfasst, der eine Seltenerde beigegeben ist, **dadurch gekennzeichnet, dass** eine Verbindung aus Silizium und Stickstoff als das Material der Deckschicht (12) gewählt wird.

13. Verfahren nach Anspruch 12, **dadurch gekennzeichnet, dass** das Material der Verbindung aus Silizium und Stickstoff in der Deckschicht in kristalliner Form ausgebildet wird.

14. Verfahren nach Anspruch 13, **dadurch gekennzeichnet, dass** die Deckschicht mittels einer Solgel-Technik ausgebildet wird.

15. Verfahren nach Anspruch 12, **dadurch gekennzeichnet, dass** das Material der Verbindung aus Silizium und Stickstoff in der Deckschicht in amorpher Form ausgebildet wird.

16. Verfahren nach Anspruch 15, **dadurch gekennzeichnet, dass** die Deckschicht mittels einer plasmaverstärkten chemischen Aufdampfungstechnik ausgebildet wird.

## Revendications

1. Dispositif de cellule solaire (10) pour convertir une énergie de rayonnement électromagnétique en une énergie électrique, lequel dispositif comprend au moins un élément photovoltaïque (11) avec une surface sensible au rayonnement, dans lequel une couche de couverture (12) dans un matériau comprenant un composé de silicium auquel une terre rare a été ajouté est présente sur la surface sensible au rayonnement de l'élément photovoltaïque (11), **caractérisé en ce que** le matériau de la couche de couverture (12) comprend un composé de silicium et nitrogène.

2. Dispositif selon la revendication 1, **caractérisé en ce que** le composé de silicium et de nitrogène absorbe substantiellement entre 350 nm et 550 nm et émet substantiellement entre 550 et 950 nm.

3. Dispositif selon la revendication 1 ou 2, **caractérisé en ce que** le composé de silicium et de nitrogène comprend du Sr₂Si₅N₈.

4. Dispositif selon la revendication 1 ou 2, **caractérisé en ce que** le composé de silicium et de nitrogène comprend du LaSi₃N₅.

5. Dispositif selon la revendication 1 ou 2, **caractérisé en ce que** le composé de silicium et de nitrogène comprend du CaAlSiN₃.

6. Dispositif selon une quelconque des revendications précédentes, **caractérisé en ce que** l'élément de terre rare comprend un élément parmi le groupe comprenant de l'europium, du cérium, du terbium et **en ce que** l'élément comprend de préférence de l'europium.

7. Dispositif selon une quelconque des revendications précédentes, **caractérisé en ce que** une paire Si-N dans le composé de silicium et de nitrogène est remplacée par substitution par une paire Al-O.

8. Dispositif selon une quelconque des revendications précédentes, **caractérisé en ce que** le composé de silicium et de nitrogène est incorporé dans une matrice de SiO₂ et TiO₂.

9. Dispositif selon une quelconque des revendications 1 à 7, **caractérisé en ce que** le composé de silicium et de nitrogène est incorporé dans une matrice de Si₃N₄.

10. Dispositif selon une quelconque des revendications précédentes, **caractérisé en ce que** l'épaisseur de la couche de couverture et l'index de réfraction du matériau de la couche de couverture sont choisis de sorte que la couche de couverture agisse comme un revêtement anti-réflexion, ou l'épaisseur est choisie de manière à être beaucoup plus grande que l'épaisseur telle que spécifiée ci-dessus qui est nécessaire pour obtenir une absorption suffisante.

11. Dispositif selon une quelconque des revendications précédentes, **caractérisé en ce que** l'élément photovoltaïque sensible au rayonnement comprend un élément semi -conducteur au silicium.

12. Procédé de fabrication d'un dispositif de cellule solaire (10) pour convertir une énergie de rayonnement électromagnétique en énergie électrique, lequel dispositif comprend au moins un élément photovoltaïque (11) avec une surface sensible au rayonnement, moyennant quoi la surface sensible au rayonnement de l'élément photovoltaïque (11) est pourvue d'une couche de couverture (12) d'un matériau comprenant un composé silicium auquel une terre rare est ajoutée, **caractérisé en ce que** un composé de silicium et de nitrogène est choisi pour le matériau de la couche de couverture (12).

13. Procédé selon la revendication 12, **caractérisé en ce que** le matériau du composé de silicium et de nitrogène dans la couche de couverture est formé de manière à être cristallin.

14. Procédé selon la revendication 13, **caractérisé en ce que** la couche de couverture est formée au moyen d'une technique sol-gel.

15. Procédé selon la revendication 12, **caractérisé en ce que** le matériau du composé de silicium et de nitrogène dans la couche de couverture est formé de manière à être amorphe.

16. Procédé selon la revendication 15, **caractérisé en ce que** la couche de couverture est formée au moyen d'une technique de dépôt chimique en phase vapeur assisté par plasma.
